# EUROPÄISCHE PATENTANMELDUNG

(11) **EP 2 760 053 A2**
(43) Veröffentlichungstag der Anmeldung: **30.07.2014**
(21) Anmeldenummer: 14152767.1
(22) Anmeldetag: 28.01.2014
(51) Int. Cl.: H01L 31/054, H01L 31/18

(54) **Licht-Konzentrator oder -Verteiler**

(30) Priorität: 29.01.2013 DE 102013100888
(71) Anmelder: Schott AG, 55122 Mainz (DE)
(72) Erfinder: Pawlowski, Edgar, 55271 Stadecken-Elsheim (DE); Beier, Wolfram, 55270 Essenheim (DE)
(74) Vertreter: Blumbach Zinngrebe

(57) **Zusammenfassung**

Licht-Konzentrator oder -Verteiler, der aus einer Mehrzahl von Lichtleitzellen (2) aufgebaut ist, die in einem transparenten Lichtleitkörper (1) aufgereiht sind. Die Lichtleitzellen (2) werden durch Grenzflächen (23) gebildet, die unter Zuhilfenahme von Laserstrahlung in dem Lichtleitkörper (1) erzeugt werden können.

## Beschreibung

Die Erfindung bezieht sich auf einen Licht-Konzentrator oder -Verteiler, insbesondere aus Glas, Glaskeramik, Optokeramik oder Kristall, zur Bündelung von Licht auf eine Mehrzahl von Lichtempfangselementen oder zur Aufspreizung und Kollimierung des Lichtes von kleinflächigen Lichterzeugern, sowie auf eine Vorrichtung mit einer Lichtquelle, einem Photodetektor oder einer Photosolarzelle und mit einem Licht- Konzentrator oder - Verteiler, ferner auf Verfahren und Vorrichtungen zur Erzeugung dieser Licht-Konzentratoren oder -Verteiler.

Unter "Licht" wird im Zusammenhang mit der Erfindung nicht nur sichtbares Licht, sondern auch infrarotes Licht, ultraviolettes Licht oder Roentgenlicht verstanden, wenn solches Licht mit dem Licht-Konzentrator oder -Verteiler genutzt werden soll.

Licht-Konzentratoren werden auf dem Gebiet der Konzentratorphotovoltaik (CPV) benötigt, um Sonnenlicht konzentriert auf kleine Flächen von Photozellen zu lenken. Der Wirkungsgrad von Photozellen ist nämlich bis zu einem gewissen Grad bei erhöhter Konzentration des Sonnenlichtes höher als bei natürlichem Sonnenschein. Als Licht-Konzentratoren werden üblicherweise Linsen und/oder diffraktiv-optische Kegelstumpfelemente verwendet, die als Vorsatzelemente von Rasteranordnungen oder Arrays von Photozellen benutzt werden. Die Vorsatzelemente können Stangenform aufweisen und werden dann im Pressverfahren hergestellt und poliert.

Beispiele für Licht-Konzentratoren als Vorsatzelemente von Solarzellen finden sich in WO 12/046376 A, WO 11/081090 A, CN 102109670 A, JP 2010212280 A, US 2010/024,867 A, CN 201289854 Y, CN 101355114 A, CN 101192632 A, US 2002/148,497 A, US 6,051,776 A, sowie JP 20000022194 A. Bei diesen bekannten Elementen wird die optische Funktion der Lichtkonzentration durch die geometrische Kontur der Elemente bestimmt, die im Querschnitt zumeist eine trichterförmige Ausbildung haben. Dies macht besonders angepasste Haltekonstruktion von Photovoltaikanlagen erforderlich, die sich wegen Schwierigkeiten der Abdichtung gegenüber Regen nicht gut in Dachflächen integrieren lassen.

Unter einem "Licht-Verteiler" wird im Zusammenhang mit der Erfindung eine Licht-Konzentrator-Anordnung verstanden, bei der das Licht die Anordnung gewissermaßen in umgekehrter Richtung durchsetzt.

Aus WO 00/71929 A1 ist ein optisches Element zur Umlenkung von Lichtstrahlen und dessen Herstellungsverfahren bekannt. Das optische Element umfasst eine transparente Platte mit in Reihen und Zeilen angeordneten pyramidenartigen Profilierungen, zwischen denen sich Furchen erstrecken, die von einer Folie mit einer reflektierenden Gitterschicht abgedeckt sind. In das optische Element eintretende Lichtstrahlen werden umgelenkt und die austretenden Lichtstrahlen an deren Austrittswinkel begrenzt. Das optische Verhalten des optischen Elements hängt von den pyramidenartigen Profilierungen ab, welche die geometrische Außenkontur der transparenten Platte bilden.

Die EP 2 487 409 A1 beschreibt einen Reflektor für Beleuchtungszwecke, der, eingebettet in einen transparenten Grundkörper, totalreflektierende Facetten oder Flächen aufweist, die durch Lasergravur erzeugt worden sind. Im Einzelnen sind die totalreflektierenden Flächen geneigt zur optischen Achse des Grundkörpers und um diese optische Achse herum verteilt angeordnet.

Ein Beleuchtungssystem für ein Flüssigkristalldisplay ist aus US 4,915,479 bekannt. Pyramidenstümpfe oder Paraboloidstümpfe sind nebeneinandergereiht, wobei deren geometrische Außenkontur die optische Funktion des Beleuchtungssystems bestimmt.

Die Anwendung der Lasergravur zur Herstellung von Beugungsgittern und reflektierenden Flächen ist vielfach bekannt (US 2012/0039567 A1, WO 2011/154701 A1, DE 101 55 492 A1 und DE 10 2011 017 329 A1). Durch die Lasergravur kann der Brechungsindex im Volumen von transparentem Material verändert werden. Auf diese Weise lassen sich Wellenleiter herstellen, die von Material mit verändertem Brechungsindex umgeben sind.

Der Erfindung liegt die Aufgabe zugrunde, Licht-Konzentratoren oder -Verteiler zu schaffen, deren optische Funktion nicht allein durch die geometrische Außenkontur bestimmt wird. Der Licht-Konzentrator oder -Verteiler soll auch in Form von Stäben oder Platten herstellbar sein, die als Strukturelemente (tragende Bauteile in Konstruktionen) nutzbar sind. Als Konzentrator eingesetzt soll das Licht konzentriert und dennoch möglichst gleichmäßig (homogen) verteilt auf eine Photovoltaikzelle oder ein anderes Lichtempfangselement zugeführt werden können. Als Lichtverteilter eingesetzt soll das Licht, ausgehend von kleinflächigen Lichterzeugern wie z.B. LEDs, OLEDs oder Laser, gleichmäßig über größere Flächen verteilt dargeboten werden können.

Im Einzelnen gibt es zur Lösung der gestellten Aufgabe einen transparenten Lichtleitkörper, der aus organischen oder anorganischen transparenten Dielektrika bestehen kann und äußerlich als Stab oder als Platte ausgebildet sein kann und in dessen Inneren sich eine Vielzahl von inneren Grenzflächen befindet, die eine Mehrzahl von Lichtleitzellen bilden. Diese Lichtleitzellen weisen eine größere und eine kleinere Basisfläche auf, wie sie bei Pyramidenstümpfen, Kegelstümpfen oder Paraboloidstümpfen vorkommen. Die Mäntel dieser Stümpfe bilden die inneren Grenzflächen im Lichtleitkörper, die das Licht durch Beugung, Reflexion oder Totalreflexion je nach Durchgangsrichtung auf die kleinere oder größere Basisfläche des Stumpfes lenken. Die im Lichtleitkörper ausgebildeten Grenzflächen setzen sich aus inneren Flächen mit örtlich stark variiertem Brechungsindex oder aus punktförmigen oder nanorissförmigen Strukturierungselementen zusammen, die in Lichtausbreitungsrichtung gesehen kleiner sind als die Lichtwellenlänge des Nutzlichtes, das mit dem Licht-Konzentrator oder -Verteiler bei dessen Einsatz benutzt werden soll. Indem die inneren Grenzflächen schräg zur Richtung des einfallenden oder austretenden Lichtes verlaufen, gibt es zumindest Reflexion oder bei größeren Einfallswinkeln gegenüber der Senkrechten Totalreflexion an diesen Grenzflächen und damit eine Hinlenkung zu der betreffenden Basisfläche der Lichtleitzelle.

Die Strukturierungselemente der inneren Grenzflächen können aus Flächen mit einem örtlich variiertem Brechungsindex oder aus sehr kleinen Volumenelementen, quasi Nulldimensionalen Elementen, hier genannt als Punktstellen, bestehen, wie sie durch fokussierte Laserbestrahlung erzeugt werden können. Solche Punktstellen weisen einen inneren Bereich erhöhten Brechungsindex und einen äußeren Bereich verringerten Brechungsindex auf, alles kleiner als die Wellenlänge des verwendeten Lichtes. Bei einem Abstand der Punktstellen, der kleiner als die Wellenlänge des verwendeten Lichtes ist, erfolgt Reflexion an der durch die Punktstellen aufgespannten inneren Grenzfläche.

Die Strukturierungselemente der inneren Grenzflächen können auch aus Nano-Rissen, quasi 1-dimensionalen Strukturen, bestehen, wie sie durch fokussierte Laserbestrahlung mit hoher Strahlqualität und guten Mikroskopobjektiven (NA > 0,8) bei Wellenlängen von z.B 180-2000 nm erzeugt werden können. Die Nano-Risse sind genügend klein gegenüber der Nutzwellenlänge, so dass sie das Nutzlicht beugen, brechen oder totalreflektieren, aber nicht überwiegend streuen, wie das bei Mikrorissen der Fall wäre.

Die Strukturierungselemente der inneren Grenzflächen können schließlich auch aus 2-dimensionalen Wandstrukturen von 3-dimensionalen Kanälen bestehen, wie sie durch Materialabtrag mittels Ätzverfahren (chemisch oder physikalisch) oder Laser erzeugt werden können. Auch hier sind Flächen mit geringer Rauhigkeit und daher mit wenig Streueffekt von Vorteil. Zu diesem Zweck kann zusätzlich eine Aufweitung der Kanäle mittels mechanischer Bearbeitung (Sägen, Schleifen oder Polieren) erfolgen, um enge Luftspalten herzustellen.

Das Material der Lichtleitkörper richtet sich nach dem Anwendungszweck der Licht-Konzentratoren oder -Verteiler. Häufig wird Glas, Glaskeramik, Optokeramik oder Kristall in Stabform oder Plattenform zum Einsatz kommen. Diese stellen ein dauerhaftes, solarisationsbeständiges und chemisch stabiles Material dar, und die äußere Form der Lichtleitkörper kann durch ein kostengünstiges Verfahren wie z.B. mit einem Heißformungsverfahren direkt aus der Schmelze oder bei den Optokeramiken durch das Pressen von Nanopulvern und einem nachfolgenden Sinterschritt hergestellt werden. Bei Verwendung von Kunststoffen kann die äußere Form der Lichtleitkörper kostengünstig durch Spritzguss, Heißformung, Blasformen oder auch spezielle Tiefziehprozesse hergestellt werden.
Als Lichteintritts-und-Austrittsfläche für die Lichtleitzellen können mit bekannten Techniken Linsenformen hergestellt werden, welche die optische Funktion der inneren Grenzflächen ergänzen. Die Lichtleitkörper können im Strangziehverfahren, im Walzverfahren, im Heißprägeverfahren oder im Kaltverarbeitungsverfahren (Schleifen oder Polieren) mit jeder gewünschten äußeren Kontur versehen werden, wonach eine oder mehrere Reihen von Lichtleitzellen im Inneren des Lichtleitkörpers erzeugt werden.

Weitere Einzelheiten der Erfindung ergeben sich aus den nachfolgenden Ausführungsbeispielen im Zusammenhang mit der Zeichnung. Dabei zeigt:
- Fig. 1a: einen stab- oder bandförmigen Licht-Konzentrator mit einer Reihe von Lichtleitzellen,
- Fig. 1b: einen stab- oder bandförmigen Licht-Konzentrator mit einer Reihe von Lichtleitzellen mit Linsen,
- Fig. 1c: einen stab- oder bandförmigen Licht-Konzentrator mit mehreren Reihen von Lichtleitzellen, die ein Lichtleitarray bilden,
- Fig. 1d: einen stab- oder bandförmigen Licht-Konzentrator in Trapezform mit einer Reihe von Lichtleitzellen,
- Fig. 1e: einen stab- oder bandförmigen Licht-Konzentrator mit einer Reihe von Lichtleitzellen mit Zylinderlinse,
- Fig. 1f: einen stab- oder bandförmigen Licht-Konzentrator mit Zylinderlinse sowie mit einer Reihe von Lichtleitzellen und mit Lichtsendern (LED, OLED oder Laser), oder mit Photodetektoren oder Photosolarzellen.
- Fig. 1g: einen stab- oder bandförmigen Licht-Konzentrator mit Konvex- und Konkavlinsen und mit einer Reihe von Lichtleitzellen sowie mit Lichtsendern (LED, OLED oder Laser), Photodetektoren oder Photosolarzellen.
- Fig. 2: Einzelne Formen von Lichtleitzellen,
- Fig. 3: einen Längsschnitt durch eine Lichtleitzelle,
- Fig. 4: eine Darstellung der optischen Lichtintensitätsfunktion, bestehend aus 8 Maxima, am unteren Rand der Lichtleitzellen,
- Fig. 5: ein erstes Herstellungsschema von Lichtleitzellen mit örtlich variierten Brechungsindex von inneren Grenzflächen,
- Fig. 6: ein weiteres Schema der Herstellung von Lichtleitzellen mit Nano-Rissen zur Bildung innerer Grenzflächen, und
- Fig. 7: ein weiteres Schema der Herstellung von Lichtleitzellen mit Kanälen zur Bildung der inneren Grenzflächen.

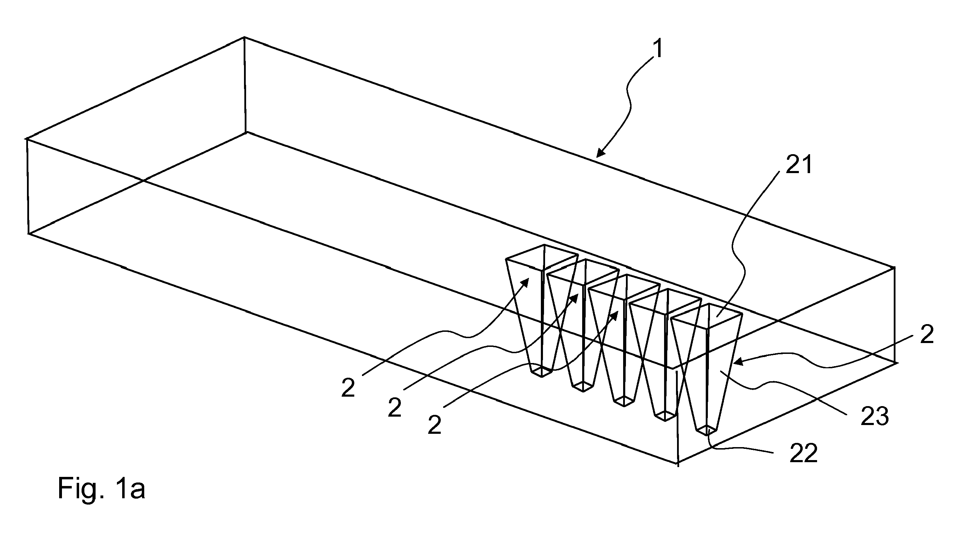

Fig. 1a zeigt einen als Zellen-Array ausgebildeten Licht-Konzentrator in perspektivischer Darstellung. Ein aus einem transparenten Dielektrikum bestehender Lichtleitkörper 1 weist eine Oberseite als Lichteintrittseite und eine Unterseite als Lichtaustrittsseite auf. Im Inneren des Lichtleitkörpers 1 ist eine Reihe von Lichtleitzellen 2 nebeneinander angeordnet und bilden ein Zeilen-Anordnung von Lichtleitern. Die Lichtleitzellen 2 haben die Form von Pyramidenstümpfen mit einer größeren Basisfläche 21 und einer kleineren Basisfläche 22 sowie mit Schrägflächen als Mantel 23. Die Basisflächen 21 oder 22 können bündig mit der Oberseite oder mit der Unterseite des Lichtleitkörpers 1 liegen, müssen es aber nicht. Möglich ist auch, dass die kleinere und/oder die größere Basisfläche im Inneren des Lichtleitkörpers angeordnet ist beziehungsweise sind, und zwar zur Oberseite beziehungsweise zur Unterseite benachbart angeordnet. Als Abmaße der Lichtleitzellen 2 kommen folgende Werte in Betracht: Seite der größeren Basisfläche: 1 bis 100 mm, bevorzugt 2 bis 25 mm; Seite der kleineren Basisfläche: 0,2 bis 50 mm, bevorzugt 0,4 bis 5 mm; Höhe der Lichtleitzellen: 0,1 bis 50 mm, bevorzugt 1 bis 10 mm; Verhältnis der Seitenlängen der Basisflächen: 1 bis 10, bevorzugt 3 bis 6.

Der Lichtleitkörper kann eine Länge und Breite im Bereich von 10 bis 2000 mm (bevorzugt 50 bis 200 mm) sowie eine Höhe im Bereich von 0,1 bis 50 mm (bevorzugt 1 bis 10mm) aufweisen, dass heißt er kann auch Plattenform mit mehreren Reihen von Lichtleitzellen 2 annehmen.

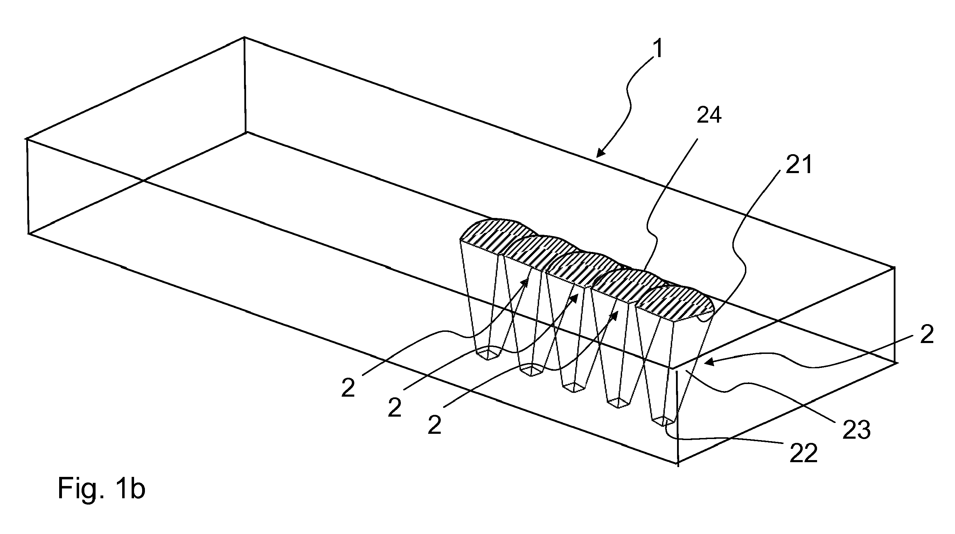

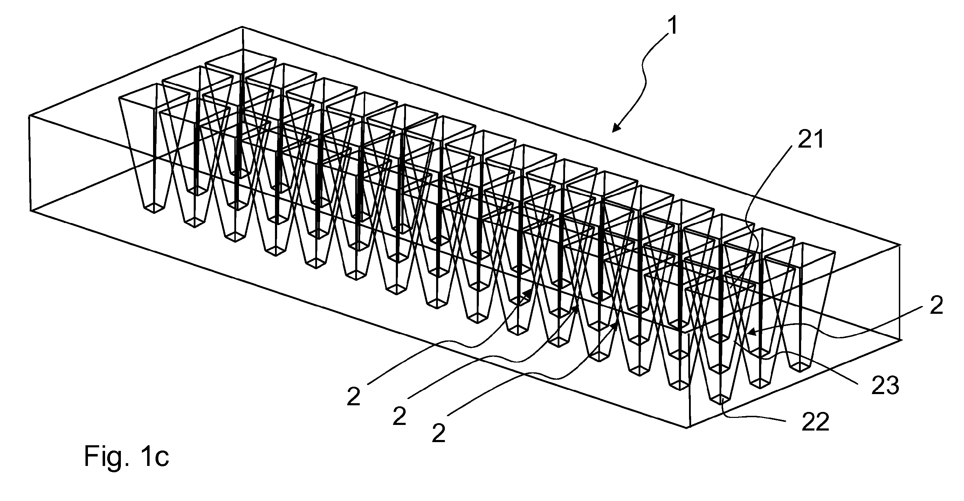

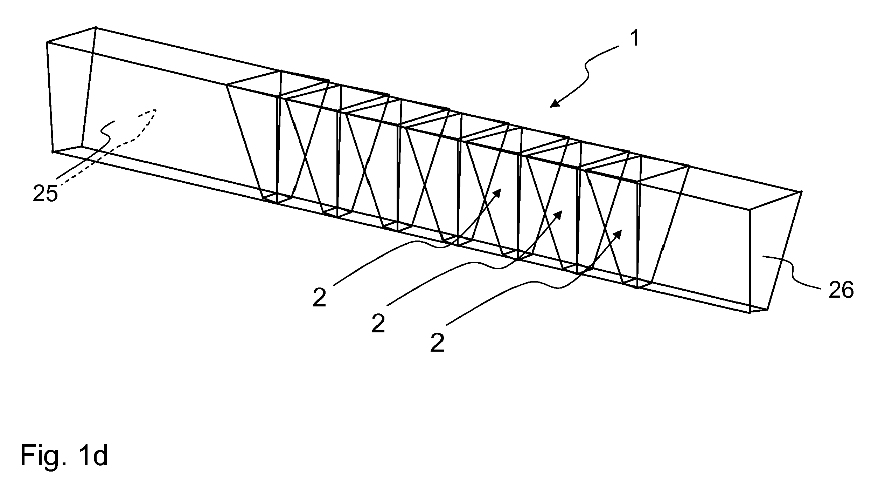

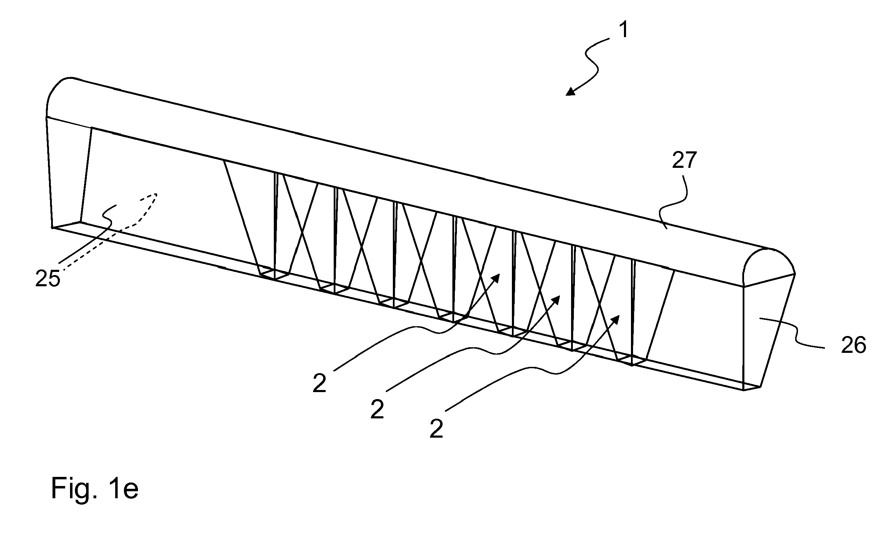

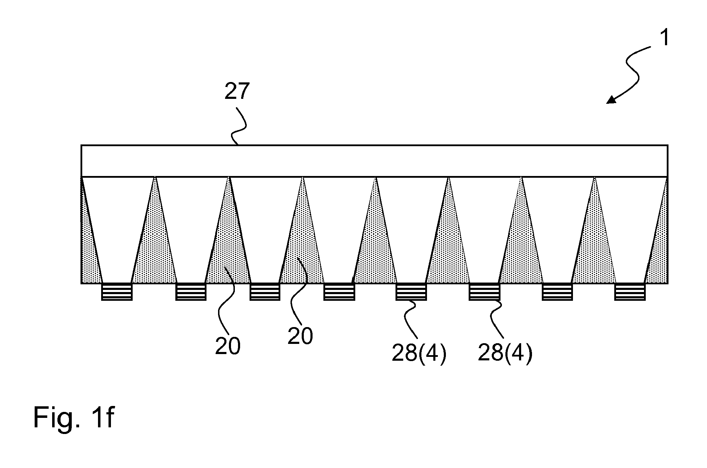

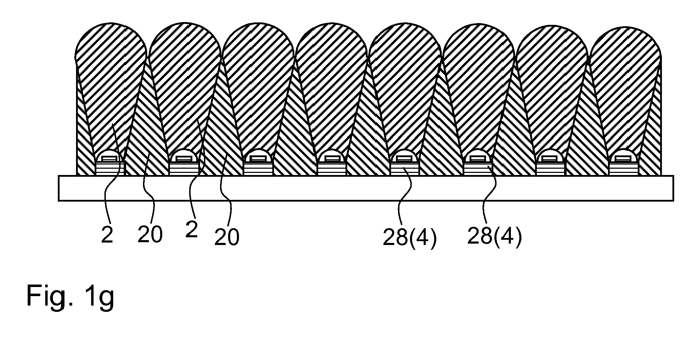

Die Ober- und Unterseite des Lichtleitkörpers nach Fig. 1a kann abweichend von der Darstellung als ebene Fläche auch eine Oberflächenstruktur aufweisen, die sich über die Lichtleitzellen 2 erstreckt und eine Lichtsammelfunktion aufweist, um mehr Licht in die jeweils zugeordnete Lichtleitzelle hineinzubringen. In diesem Sinne zeigt die Fig. 1 b einen als Zellen-Array ausgebildeten Licht-Konzentrator in perspektivischer Darstellung. Die Lichtsammelfunktion kann durch eine gewölbte Fläche 24 über jeder einzelnen Lichtleitzelle 2 in sphärischer, asphärischen oder freien Form verwirklicht werden.

Fig. 1c zeigt einen als 2D-Zellen-Array ausgebildeten Licht-Konzentrator in perspektivischer Darstellung.

Fig. 1d zeigt einen als 1D-Zellen-Array ausgebildeten Licht-Konzentrator in perspektivischer Darstellung. Die Seitenflächen 25 laufen aufeinander zu. Die Querschnittsflächen 26 sind als Trapez ausgebildet. Die Seitenflächen können abweichend von der Darstellung auch parabolisch geformt sein.

Fig. 1e zeigt einen als 1D-Zellen-Array ausgebildeten Licht-Konzentrator in perspektivischer Darstellung mit Zylinderlinse 27.

Fig. 1f zeigt einen stab- oder bandförmigen Licht-Konzentrator mit einer Reihe von Lichtleitzellen mit Zylinderlinse 27 und Lichtsendern 28 (LED, OLED oder Laser)oder mit Photodetektoren bzw. Photosolarzellen 4. Als Photosolarzelle können organische oder anorganische Dünnschichtzellen, kristalline Zellen oder Mehrfachzellen verwendet werden. Zwischen den Lichtleitzellen 2 befindet sich je ein Keilraum 20, der mit Luft oder einem Füllmaterial gefüllt ist, dessen Berechnungsindex kleiner als der Berechnungsindex des Materials der Lichtleitzellen 2 ist.

Fig. 1g zeigt einen stab- oder bandförmigen Licht-Konzentrator mit einer Reihe von Lichtleitzellen mit Konvex- und Konkavlinsen an Ober- und Unterseite jeder Lichtleitzelle 2 und mit Lichtsendern 28 (LED, OLED oder Laser), oder mit Photodetektoren oder Photosolarzellen 4 auf einem Kühlkörper.

Wenn der Lichtleitkörper 1 mit einem Lichtsender 28 bei der kleineren Basisfläche 22 betrieben wird, kann man von einer Beleuchtungseinrichtung sprechen, die über die größere Basisfläche 21 bzw. über eine Linse 24 oder 27 Nutzlicht abgibt.

Es ist auch möglich, das Nutzlicht durch Lichtkonversion zu gewinnen. In einem solchen Fall benutzt man ein transparentes Dielektrikum, das mit einem Licht konvertierenden oder fluoreszierenden Material dotiert ist und das 50 % oder mehr des Lichtsendelichtes passieren lässt und den Rest absorbiert bzw. konvertiert.

Wenn der Lichtleitkörper der Fig. 1f, 1g Photodetektoren bzw. Photosolarzellen 4 aufweist und mit Außenlicht, z.B. Sonnenlicht beaufschlagt wird, dann kann man von einer Photoempfängervorrichtung oder einer Photovoltaische Vorrichtung sprechen. Bei diesen Vorrichtungen können vorteilhaft stabförmige und plattenförmige Bauformen der Lichtleitkörper 1 benutzt werden.

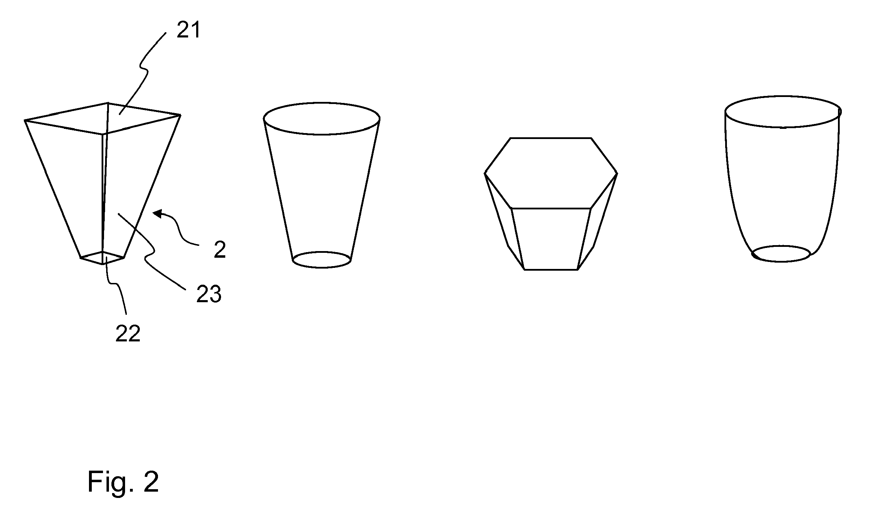

Fig. 2 zeigt mehrere mögliche Formen der Lichtleitzellen 2, darunter einen Pyramidenstumpf, einen Kegelstumpf, eine konische Wabe und einen Paraboloidstumpf.

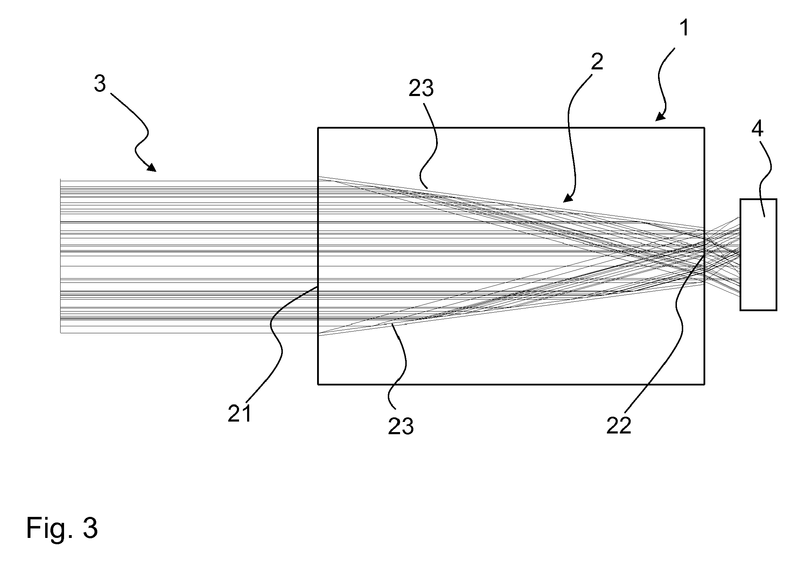

Fig. 3 zeigt einen Längsschnitt durch eine Lichtleitzelle 2 im Zusammenwirken mit einem Lichtbündel 3, das an der Basisfläche 21 der Lichtleitzelle eintritt, an den Schrägflächen des Mantels 23 reflektiert wird und an der kleinen Basisfläche 22 austritt. Unmittelbar hinter der kleinen Basisfläche 22 kann sich eine Photozelle 4 der Photovoltaikanlage befinden. Wenn die größere Basisfläche 21 die Größe A aufweist und die kleine Basisfläche die Größe a, dann wird die auf der Photozelle ankommende Lichtintensität um den Faktor A/a erhöht.

Es versteht sich, dass die Lichtleitzelle 2 auch in umgekehrter Richtung, mit der kleineren Basisfläche 22 als Lichteintrittsseite und der größeren Basisfläche 21 als Lichtaustrittsseite benutzt werden kann. Eine solche Anordnung kann als Leuchtfeld dienlich sein.

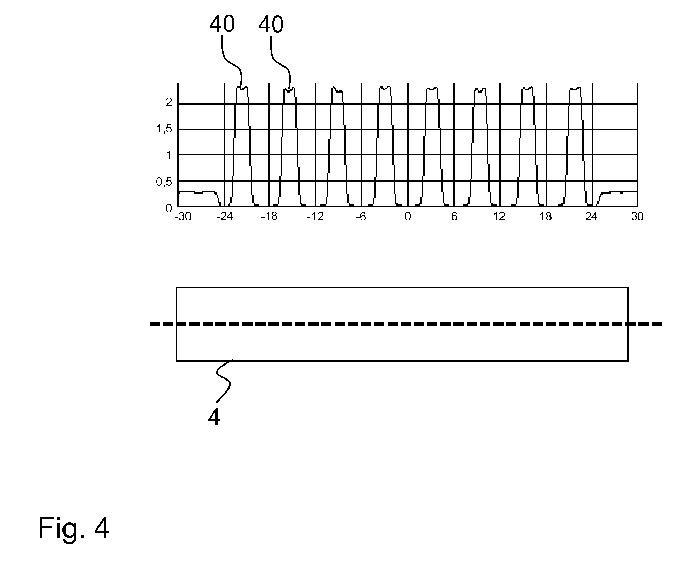

Fig. 4 zeigt die Wirkungsweise einer Zeile von Lichtleitzellen, die mit Licht bestrahlt werden, auf eine Photozelle oder einen Detektor 4, dessen Nachweisstrom dargestellt ist. Einfallendes Licht durchsetzt den Lichtleitkörper mit den Lichtleitzellen darin und tritt konzentriert an den kleineren Basisflächen der Lichtleitzellen aus. Jeder Lichtleitzelle ist ein Lichtaustrittskegel mit einigermaßen ebener Spitze zugeordnet. Das bildet sich in dem Verlauf des Nachweisstromes 40 ab.

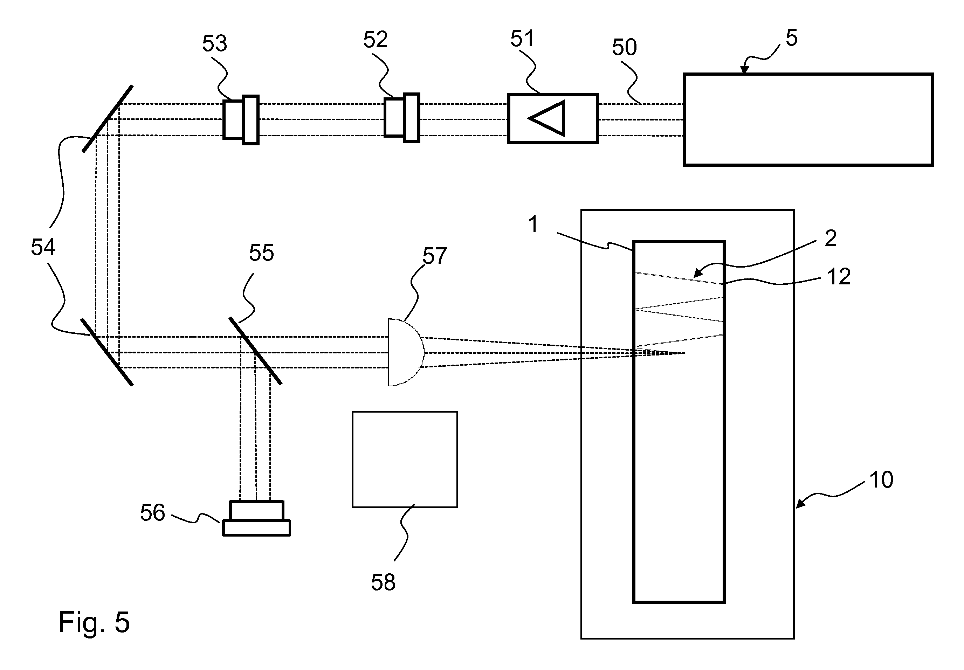

Fig. 5 zeigt eine Anlage zur Erzeugung eines Licht-Konzentrators oder -Verteilers. Ein Laser 5, zum Beispiel ein Titan-Saphir-Laser (Ti:Al₂O₃-Laser) mit einer Pulsbreite kleiner 100 fs und einer Wellenlänge von etwa 850 nm wird modengelockt betrieben und gibt seine Strahlung 50 über eine optische Diode 51, eine λ/2-Platte 52 und einen Polarisator 53 sowie gegebenenfalls über ein Umlenksystem 54 an einen Strahlteiler 55 ab, der einen kleineren Leistungsteil an einem Leistungsmesser 56 ablenkt und einen größeren Leistungsteil einem Mikroskopobjektiv 57 (Leistungswerte 100x, NA:0,8) zuführt. Die Laserstrahlung wird innerhalb des Lichtleitkörpers 1 fokussiert, der als Werkstück in einem Werkstückhalter 10 platziert ist. Der Werkstückhalter 10 ist relativ zu dem Mikroskopobjektiv 57 in X-, Y- und Z-Richtung fein verstellbar. Hierzu können 3D-piezoelektrische Verstellmotore zusammen mit Präzisionswälzlager und Linearführungen verwendet werden. Die Messeinrichtung ist interferometrisch. Es werden Wiederholgenauigkeiten solcher Verschiebeeinheiten besser als 2 nm erreicht. Eine Steuereinrichtung 58 ist mit dem Laser 5, dem Leistungsmesser 56 und dem Werkstückhalter 10 verbunden, um den Ablauf der Bearbeitung des Lichtleitkörpers 1 zu steuern und zu regeln. Es können auch andere Laser mit einer Pulsbreite < 1 psec und mit einer Wellenlänge im Bereich 180 nm bis 2000 nm verwendet werden.

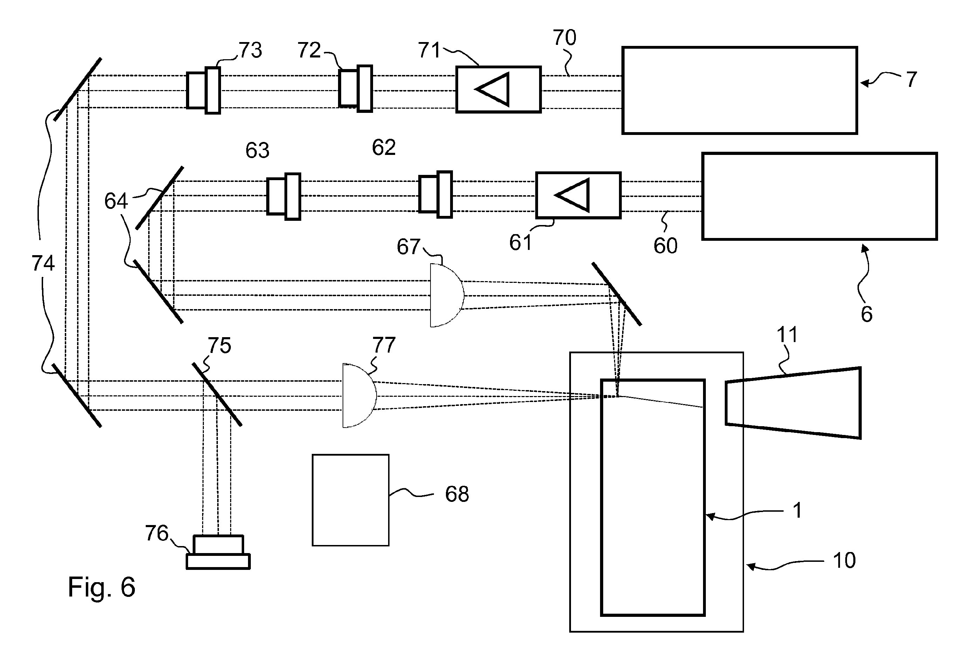

Fig. 6 zeigt ein weiteres Schema der Bearbeitung eines Lichtleitkörpers 1 zur Herstellung eines Licht-Konzentrators. Es sind zwei Laser 6 und 7 zur Abgabe von Laserstrahlung 60 beziehungsweise 70 hoher Strahlqualität M < 2 vorgesehen, das über optische Dioden 61 beziehungsweise 71, λ/2-Platten 62 beziehungsweise 72, Polarisatoren 63 beziehungsweise 73, Umlenksysteme 64 beziehungsweise 74 je einem Mikroskopobjektiv 67 beziehungsweise 77 (Leistungswerte 100X, NA > 0,8) zugeführt wird, die auf eine Punktstelle in dem Lichtleitkörper 1 fokussieren. Außerdem ist noch eine Steuereinrichtung 68 vorgesehen, die die Laser 6, 7, einen Leistungsmesser 76 sowie den fein verstellbaren Werkstückhalter 10 steuert. Im Bereich des Werkstückhalters 10 kann eine Absaugeinrichtung 11 vorgesehen sein. Der Laser 6 ist zum Beispiel ein Neodym-Granat-Laser (Nd-YAG-Laser), der frequenzverdreifacht mit 354,6 nm Wellenlänge bei einer Impulsbreite von 1 ps betrieben werden kann. Der Laser 7 ist zum Beispiel ein XeF-Laser mit einer Betriebswellenlänge von 351 nm und einer möglichen Pulsbreite von 1 ps. Es können aber auch andere Lasertypen im Wellenlängenbereich von 180 nm bis 2000 nm verwendet werden. Es ist vorteilhaft, wenn sich die Wellenlängen der beiden Laser unterscheiden.

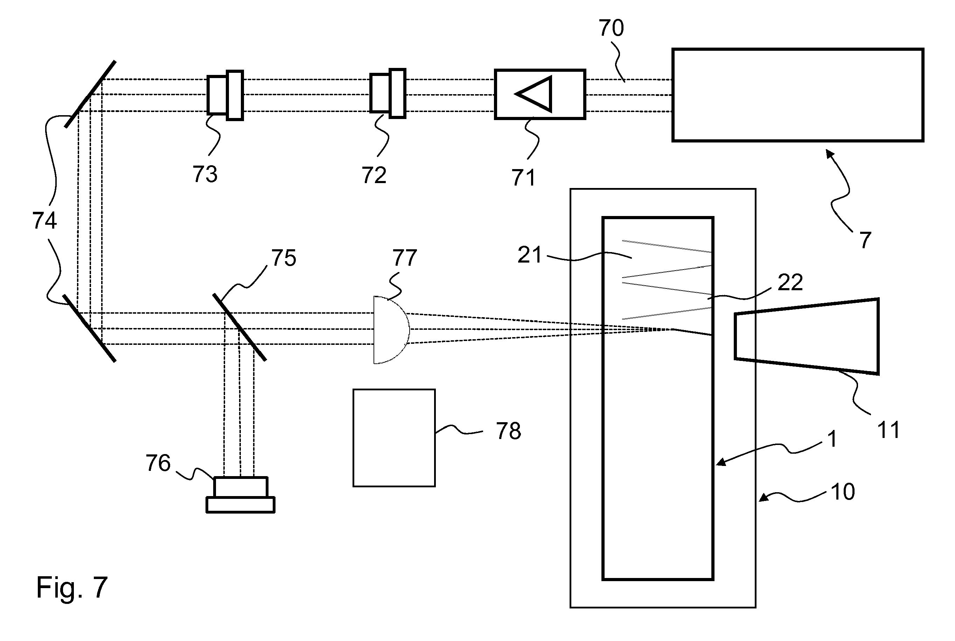

Fig. 7 zeigt eine Anlage zur Erzeugung von Licht-Konzentratoren mit inneren Grenzflächen aus Kanälen. Mit Fig. 6 übereinstimmende Vorrichtungsteile werden mit den gleichen Bezugszeichen belegt. Wie zuvor ist eine Steuereinrichtung 78 zur Steuerung des Lasers 7, des Laser-Leistungsmessers 76 und des fein verstellbaren Werkstückhalters 10 vorgesehen. Der Laser 7 ist zum Beispiel ein gepulster UV-Laser (λ = 351 nm) mit hoher Energiedichte größer 100 J/cm². Die Pulsbreiten liegen im Bereich von 100 fs bis 10 ns. Das Mikroskopobjektiv 77 hat Werte von 50x, NA = 0,8. Es können aber auch andere Lasertypen mit einer Laseremission im Wellenlängenbereich von 180 nm bis 2000 nm verwendet werden.

Ausgehend von einem Lichtleitkörper aus einem transparentem Dielektrikum, insbesondere Glas, Glaskeramik, Optokeramik oder Kristall, erfolgt die Herstellung der Licht-Konzentratoren mit inneren Grenzflächen aus Punktstellen von örtlich variiertem Brechungsindex mit der Anlage nach Fig. 5. Die Laserstrahlung 50 wird mit ausreichender Feldstärke an einen Punkt 12 fokussiert, der an einer Schnittstelle zwischen den Schrägflächen des Mantels 23 der Lichtleitzelle 2 und der kleinen Basisfläche 22 einer Lichtleitzelle 2 liegt. Bedingt durch die hohe Feldstärke am Brennpunkt entsteht eine örtliche Verdichtung des Materials mit Erhöhung des Brechungsindexes an dieser Punktstelle und eine Verringerung der Verdichtung um die Verdichtungsstelle herum mit einer Erniedrigung des Brechungsindexes, dass heißt, eine Punktstelle mit örtlich variiertem Brechungsindex. Nunmehr wird der Werkstückhalter 10 parallel zur Oberseite oder Unterseite des Lichtleitkörpers in Y- oder Z-Richtung um ein Stück verfahren, das weniger als die Wellenlänge des Nutzlichtes beträgt, mit dem der Licht-Konzentrator verwendet werden soll. Es wird ein Laserblitz abgegeben und damit erneut eine Punktstelle mit örtlich variiertem Brechungsindex erzeugt. In dieser Weise werden Punktstellen durch "Einschreiben" aneinandergereiht, bis eine Zeile entlang oder parallel zur Kante zwischen einer Mantelschrägfläche 23 und der kleinen Basisfläche 22 vervollständigt worden ist. Danach wird das Werkstück in X-Richtung um einen Betrag verstellt, der kleiner als die Wellenlänge des Nutzlichtes ist, mit dem der Licht-Konzentrator verwendet werden soll. Es wird mit der Erzeugung von neuen Punktstellen durch "Einschreiben" entlang einer Zeile fortgefahren, die sich entlang der Y- oder Z-Achse erstreckt, je nachdem, welche Schrägfläche des Mantels 23 des Pyramidenstumpfes erzeugt wird. Wenn auf diese Weise alle Schrägflächen des Pyramidenstumpfes erzeugt worden sind, beginnt man mit der Erzeugung einer neuen Lichtleitzelle.

Der Laserbeschuss hat die Ätzselektivität des Materials an den erzeugten Grenzflächen verändert. Mit nasschemischem Ätzen des Lichtleitkörpers lassen sich die Rauhigkeiten reduzieren und damit die totalreflektierenden Eigenschaften der inneren Grenzflächen verstärken.

Licht-Konzentratoren aus Glas, Glaskeramik, Optokeramik oder Kristall mit Nano-Rissen entlang der inneren Grenzflächen der Lichtleitzellen lassen sich mit der Anlage nach Fig. 6 erzeugen. Mikrorisse entstehen durch sehr hohe Leistungen größer 1 MW/cm². Wenn Mikrorisse mit zu großen Querschnitten erzeugt werden, entsteht unerwünscht hohe Lichtstreuung mit Nutzlicht bei dem fertigen Licht-Konzentrator. Um dies zu vermeiden, wird kurzwelliges Licht im UV-Bereich bei einer Wellenlänge kürzer als 360 nm zur Erzeugung von "Nano-Rissen" verwendet, wie man dies bei einem frequenzverdreifachten Nd-YAG-Laser (λ = 354,6 nm) oder einem XeF-Laser mit einer Betriebswellenlänge von 351 nm erreichen kann. Dabei soll ein Schwellenwert von größer 2 J/cm² bei Pulsbreiten von 1 ps überschritten werden. Außerdem kann man zwei fokussierte Strahlen 60, 70 an dem zu erzeugenden Nanoriss kreuzen, wie in Fig. 6 dargestellt. Damit gelangt man zu einer Ausdehnung des Risses kleiner 400 nm, so dass die Bezeichnung "Nano-Riss" gerechtfertigt ist. Die Punktstellen mit der angegebenen kleinen Ausdehnung erzeugen in ihrer Gesamtheit die inneren Grenzflächen, bei denen das Nutzlicht überwiegend reflektiert und nur geringfügig gestreut wird. Für die Verwendung des Licht-Konzentrators im IR-Spektralbereich kann die verwendete Laserwellenlänge auch größer sein. Vorteilhaft ist die Verwendung einer Laserwellenlänge kleiner als die Lichtnutzungswellenlänge. Es können daher auch andere Lasertypen mit einer Laseremission im Wellenlängenbereich von 180-2000 nm verwendet werden.

Wie im Falle der Fig. 5 wird auch im Falle der Fig. 6 mit der Erzeugung der Nano-Risse als Strukturierungselemente in der Nähe der kleineren Basisfläche 22 begonnen, damit eventuell entstehende Gase abgesaugt werden können. Die Schrägflächen des Mantels 23 werden durch Einschreiben erzeugt, dass heißt Punkt für Punkt und Zeile für Zeile abgefahren, bis die inneren Grenzflächen komplettiert sind. Es wird mit einem ausreichend kleinen Abstand der Punkte oder Nano-Risse voneinander gearbeitet, was von der Wellenlänge des angewendeten Lichtes im fertigen Licht-Konzentrator oder -Verteiler abhängt. Der Punktabstand sollte in der Größenordnung des angewendeten Lichtes oder kleiner sein und ist kleiner als 500 nm, bevorzugt kleiner als 100 nm sowie besonders bevorzugt kleiner als 20 nm.

Ebenso wie im Falle der Fig. 5 kann auch im Falle der Fig. 6 der Lichtleitkörper mit den punktförmigen oder nanorissförmigen Strukturierungselementen nasschemisch, anisotrop geätzt werden, um die Licht ablenkende Wirkung der inneren Grenzflächen zu verstärken.

Die Herstellung der inneren Grenzflächen aus Wandstrukturen von Kanälen wird anhand der Fig. 7 erläutert. Wie im Falle der Fig. 5 wird auch im Falle der Fig. 7 in der Nähe der kleinen Basisfläche 22 mit der Bearbeitung des Lichtleitkörpers aus Glas, Glaskeramik, Optokeramik oder Kristall begonnen. Der Laser 7 ist zum Beispiel ein gepulster UV-Laser mit λ = 351 nm, da die Lichtabsorption in Glas bei UV-Strahlung sehr hoch ist. Die Energiedichte wird im Bereich größer 100 J/cm² gewählt. Günstige Pulsbreiten liegen im Bereich von 100 fs bis 10 ns. Wie im Falle der Vorgehensweise nach Fig. 5 wird auch im Falle der Fig. 7 mit der Herstellung der inneren Wandstrukturen in der Nähe der kleinen Basisfläche 22 begonnen. Die Kanäle werden zeilenmäßig durch Laserablation in X-, Y- oder Z-Richtung erzeugt, wodurch die Mantelschrägflächen 23 der Lichtleitzellen 2 gewonnen werden. Bei der Laserablation entstehen Dämpfe, die durch die Absaugeinrichtung 11 entfernt werden.

Wie in Fig. 7 angedeutet, befindet sich die größere Basisfläche 21 mit etwas Abstand von der Oberfläche des Lichtleitkörpers 1. Auf diese Weise wird vermieden, dass der Lichtleitkörper mechanisch zu stark geschwächt wird. Diese Maßnahme der Beabstandung der größeren Basisfläche von der Oberseite des Lichtleitkörpers kann im Übrigen auch bei den Gestaltungen gemäß den Herstellungsverfahren nach Fig. 5 und 6 angewendet werden. Im Übrigen können auch die mit der Vorrichtung der Fig. 7 erzeugten Kanäle nasschemisch, anisotrop geätzt werden.

Es ist auch möglich, die Mantelschrägflächen 23 der Lichtleitzellen 2 mit Hilfe von Sägen, Schleifmittel und Poliermittel zu bearbeiten, nachdem eine Schwächung des Lichtleitzellenmaterials entlang der prospektierten Grenzflächen vorgenommen worden ist. Die Schwächung kann durch Laserbestrahlung, gegebenenfalls auch durch zusätzliches Ätzen bewirkt werden.

Die Herstellung der inneren, schrägen Grenzflächen 23 mit fokussierten Laserstrahlung senkrecht zur Oberfläche des Lichtleitkörpers ist keine Notwendigkeit; man kann die Laserstrahlrichtung mit der Schräge der inneren Grenzflächen 23 zusammenfallen lassen, wodurch sich eine Glättung dieser Grenzflächen trotz punktförmiger Erzeugung ergibt. Dies kann insbesondere bei der Herstellung der Grenzflächen aus Kanälen gemäß Fig. 7 bedeutsam sein.

Als Ausgangsmaterial der transparenten Lichtleitkörper eignen sich prinzipiell alle transparenten Dielektrika, ob organischer oder anorganischer Natur.

### Als organische Materialien seien genannt:

Bei Kunststoffen (Polymeren): Thermoplaste (nichtkristallin, teilkristallin oder kristallin); Duromere; Elastomere; Thermoplastische Elastomere; Cyclic Olefin Copolymere (COC).

### Als anorganische Materialien seien genannt:

- Silicatgläser (zum Beispiel Kieselgläser (viele Varianten, insb. der Typen I, II, III und IV, d.h. aus Quarz erschmolzene, synthetisch aus SiF4 hergestellte usw.); Alkalisilicatgläser; Alkali-Erdalkalisilicatgläser (z.B. Natronkalksilicatgläser oder: Natronkalikalksilicatgläser, d.h. Mischalkalikalksilicatgläser oder: Mischalkalistrontiumsilicatgläser, Mischalkalibariumsilicatgläser usw.; Borosilicatgläser (wie z.B. die Schott-Gläser DURAN, FIOLAX, SUPRAX..., insb. eisenarme Varianten davon); Phospho-Silicatgläser (z.B. das Schott-Glas SUPREMAX); Borophospho-Silicatgläser; Aluminosilicatgläser (z.B. Alkali-Aluminosilicatgläser, Alkali-Erdalkali-Aluminosilicatgläser usw., z.B. die GORILLA-Varianten von Corning oder XENSATION-Glas von Schott); Boro-Aluminosilicatgläser, insb. alkalifreie, z.B. die EAGLE-Gläser von Corning; Borophospho-Aluminosilicatgläser; Diverse weitere, z.B. solche, die weitere Minderheitskomponenten oder speziellen Läutermitteln enthalten; Alle obigen und weitere, aber nicht schmelztechnisch hergestellt, sondern nach einem der vielen Sol-Gel-Verfahren);
- Boratgläser;
- Phosphatgläser;
- Fluorphosphatgläser (das sind i.a. optische Gläser);
- Weitere optische Gläser (solche mit "Standardkomponenten" (z.B. das Schott-Glas BK7); solche mit speziellen Komponenten wie Bleioxid, Lanthanoxid, Vanadiumpentoxid usw., z.B. das Schott-Glas SF6);
- Lumineszierende Gläser (Sind i.a. seltenerdhaltig und daher lumineszierend. Solche fluoreszierenden oder phosphoreszierenden Gläser, in welche die erfindungsgemäßen, lichtlenkenden Strukturen eingeschrieben werden, kombinieren die Funktion "Lichtlenkung" mit der Funktion "Frequenzumwandlung" bzw. einem "Lasereffekt".) Lasergläser; Konversionsgläser, usw.);
- Solarisationsbeständige Gläser (z.B. mit Ceroxid stabilisierte Gläser), insb. optische Gläser; weltraumtaugliche Gläser
- Tellurat- beziehungsweise Telluritgläser;
- Halogenidgläser (sind i.a. transparent im Infraroten), Fluoridgläser (einfachster, klassischer Fall: MgF2; darüber hinaus viele komplexe Zusammensetzungsbereiche; Chlorid-, Bromid-, Jodgläser; Gläsern mit mehreren unterschiedlichen (Halogen-)Anionen; Gläser, die neben Halogen-Anionen auch Sauerstoff als Anion enthalten, siehe z.B. die bereits erwähnten Fluorophosphatgläser;
- Chalkogenidgläser (sind i.a. nicht transparent im Sichtbaren, aber oft transparent im Infraroten bis zu besonders großen Wellenlängen); Sulfidgläser; Selenidgläser, Ternäre, quaternäre oder noch komplizierter zusammengesetzte Gläser, z.B. aus den Systemen Ge-Se-As-Ge, Ge-S-As, Ge-Se-Sb, Ge-S-As...
- Chalkohalidgläser (oft transparent im Infraroten)
- Glaskeramiken (die im interessierenden Wellenlängenbereich transparent sind)
- Glaskeramiken (die aus erschmolzenen "Grüngläsern" durch gezielte, thermische Teilkristallisation hergestellt wurden): LAS-Glaskeramiken; MAS-Glaskeramiken; BAS-Glaskeramiken; extrem viele weitere mit diversen weiteren Bestandteilen bzw. Kombinationen daraus, z.B. yttriumhaltige Glaskeramiken; BaTi03-haltige Glaskeramiken...; extrem viele weitere mit jeweils charakteristischer Kristallitgröße oder -form; Kristallitgrößenverteilungen; Texturen.
- Sinterglaskeramiken (die aus Preßlingen von glasigen oder/und bereits kristallinen/teilkristallinen Pulvern hergestellt wurden): große Vielfalt, analog zu den aus massivem Grünglas hergestellten GKn; Sinterglaskeramiken können verschiedene Lumineszenzmaterialien enthalten. Die Lumineszenzmaterialien können z.B. zusammengesetzt sein aus unterschiedlichen Eu dotierten Materialien wie CaS:Eu, Sr₂Si₅N₈:Eu, SrS:Eu, Ba₂Si₅N₈:Eu, Sr₂SiO₄:Eu, SrSi₂N₂O₂:Eu, SrGa₂S₄:Eu, SrAl₂O₄:Eu, Ba₂SiO₄:Eu, Sr₄Al1₄O₂₅:Eu, SrSiAl₂O₃N:Eu, BaMgAl₁₀O₁₇:Eu, Sr₂P₂O₇:Eu, SrB₄O₇:Eu, Y₂O₃:Eu, YAG:Eu, Ce:YAG:Eu, (Y, Gd)BO₃:Eu, (Y,Gd)₂O₃:Eu. Lumineszenzmaterialien können co-dotiert oder auch mit anderen Seltenen Erden (Scandium, Yttrium, Lanthan, Cer, Praseodym, Neodym, Promethium, Samarium, Gadolinium, Terbium, Dysprosium, Holmium, Erbium, Thulium, Ytterbium und Lutetium) dotiert werden (z.B. LaPO₄:Ce,Tb, LaMgAl₁₁O₁₉:Ce,Tb, (Y, Gd, Tb, Lu) AG: Ce, Lu_{3-x-z}AₓAl_{5-y-z}Sc_{y}O₁₂:Mn_{z}Ca_{z}, Lu₂SiO₅:Ce, Gd₂SiO₅:Ce, Lu_{1-x-y-a-b}YₓGd_{y})₃ (Al_{1-z}Ga)₅O₁₂:CeₐPr_{b}). Günstige Lumineszenzmaterialien für VUV Anregung sind LaPO₄:Pr, YPO₄:Pr, (Ca,Mg)SO₄:Pb, LuBO₃:Pr, YBO₃:Pr, Y₂SiO₅:Pr, SrSiO₃:Pb, LaPO₄:Ce, YPO₄:Ce, LaMgAl₁₁O₁₉:Ce . Bei Anregung mit Röntgenstrahlen können beispielhaft die folgenden Lumineszenzmaterialien verwendet werden: InBO₃:Tb+InBO₃:Eu, ZnS:Ag, Y₂O₂S:Tb, Y₂SiO₅:Tb, Y₃(Al,Ga)₅O₁₂:Ce, (Zn,Cd)S:Cu,Cl+(Zn,Cd)S:Ag,Cl, Y₃(Al,Ga)₅O₁₂:Tb, Zn₂SiO₄:Mn, Zn₈BeSi₅O₁₉ :Mn, CaWO₄:W, Y₂O₂S:Eu+Fe₂O₃, (Zn,Mg)F₂:Mn, Y₃Al₅O₁₂:Tb.
- Optokeramiken (Das sind i. a. durch Sintern hergestellte Keramiken, die im interessierenden Wellenlängenbereich transparent sind, d.h. die sehr kleine Körner oder/und brechzahlangepaßte Korngrenzen aufweisen. Die Struktur von Optokeramiken ist in der Regel polykristallin): Spinell-Optokeramiken; Pyrochlor-Optokeramiken; YAG-Optokeramiken; LuAg-Optokeramiken; Yttria-Optokeramiken; ZnSe:Te-Optokeramiken; GOS: Pr, Ce, F, YGO: Eu, Tb, Pr; GGG: Cr, Ce; Seltenerdenhaltige (Y, Gd, Tb, Dy, Ho, Er, Tm, Yb, Lu, Sc, La, Ce, Pr, Nd, Pm, Sm, Eu) und deshalb aktive Optokeramiken
- Kristalle (Einkristalle): Saphir (A1203); Andere Oxide z.B. Zr02; Spinell (diverse Zusammensetzungen/Mischungsreihen); Pyrochlor (sehr viele Zusammensetzungen/Stoffsysteme); CaF

Viele der oben aufgelisteten Materialien sind nicht nur im sichtbaren, sondern auch mehr oder weniger weit im Infraroten hinreichend transparent. Somit können in diese mit den erfindungsgemäßen Verfahren analoge, IR-optisch wirksame Strukturen eingeschrieben werden, wofür wiederum Infrarot-Laser als Werkzeuge ausreichen. Aufgrund der größeren Wellenlängen können hierbei Spot-Größe und Strukturierung gröber sein.

Manche der oben aufgelisteten Materialien wie z.B. Kieselgläser oder hocheisenarme Gläser sind auch mehr oder weniger weit im Ultravioletten hinreichend transparent. Entsprechend können in diese mit den erfindungsgemäßen Verfahren auch UV-optisch wirksame Strukturen eingeschrieben werden, wobei jetzt aber die Spot-Größe kleiner und die Strukturierung feiner sein müssen.
Einige der aufgelisteten Materialien sind geeignet um Anteile des Lichtspektrums in eine andere Wellenlänge oder ein Wellenlängenspektrum zu konvertieren. Dies ermöglicht einerseits eine Erhöhung der Effizienz von Solarzellen, da der Wirkungsgrad von Photosolarzellen wellenlängenabhängig ist. Anderseits kann auch Roentgenlicht in sichtbares Licht konvertiert werden. Bei Verwendung von Leuchtquellen wie LED, OLED oder Laser kann das emittierte Licht auch in eine andere Wellenlänge oder in ein anders Wellenlängenspektrum konvertiert werden.

## Patentansprüche

1. Licht-Konzentrator oder -Verteiler zur Bündelung von Licht auf eine Mehrzahl von Lichtempfangselemente oder zur Aufspreizung und Kollimierung des Lichtes von kleinflächigen Lichterzeugern, umfassend:
einen transparenten Lichtleitkörper (1) aus einem transparenten Dielektrikum mit einer Mehrzahl von Lichtleitzellen (2) im Inneren des Lichtleitkörpers, die in Form von Pyramidenstümpfen, Kegelstümpfen, Paraboloidenstümpfen oder konischen Waben ausgebildet sind und jeweils zueinander eine größere und eine kleinere Basisfläche (21, 22) aufweisen sowie deren Mäntel (23) als innere Grenzflächen im Lichtleitkörper (1) ausgebildet sind, wobei die inneren Grenzflächen in die jeweiligen Lichtleitzellen (2) eintretendes Licht durch Beugung, Reflexion oder Totalreflexion auf eine der Basisflächen (21, 22) der jeweiligen Lichtleitzelle (2) zu lenken vermögen und die inneren Grenzflächen der jeweiligen Lichtleitzelle (2)sich aus Brechungsindexsprüngen im Lichtleitkörper oder aus punktförmigen oder nanorissförmigen Strukturierungselementen im transparenten Dielektrikums des Lichtleitkörpers zusammen setzen.

2. Licht-Konzentrator oder -Verteiler nach Anspruch 1,
wobei die inneren Grenzflächen der jeweiligen Lichtleitzelle (2) aus Wandstrukturen von Kanälen oder aus Luftspalten bestehen.

3. Licht-Konzentrator oder -Verteiler nach Anspruch 2,
wobei die Kanäle der jeweiligen Lichtleitzelle (2) durch Materialabtrag mittels Laser erzeugt sind und durch Ätzen erweitert sind.

4. Licht-Konzentrator oder -Verteiler nach einem der Ansprüche 1 bis 3,
wobei die Lichtleiterzellen (2) in einer oder mehreren Reihen angeordnet sind und wobei der transparente Lichtleitkörper (1) Stabform oder Plattenform mit einer oder mehreren Reihen von Lichtleitzellen (2) aufweist.

5. Licht- Konzentrator- oder Verteiler nach einem der Ansprüche 1-4,
wobei jeder Lichtleitzelle (2) oder jeder Reihe von Lichtleitzellen (2) eine optische Linse (24,27) zugeordnet ist.

6. Beleuchtungsvorrichtung mit einer kleinflächigen Lichtquelle und einem Lichtverteiler nach einem der Ansprüche 1-5,
wobei die kleinflächige Lichtquelle mindestens eine LED, oder einen OLED, oder einen Laser umfasst und an der kleineren Basisfläche (22) der Lichtleitzelle (2) angeordnet ist und Licht in einem bestimmten Wellenlängenbereich abgibt.

7. Beleuchtungsvorrichtung nach Anspruch 6,
wobei das transparente Dielektrikum des Lichtleitkörpers (1) mit einem fluoreszierenden Material dotiert ist, um Anteile des eintretenden Lichtes des bestimmten Wellenlängenbereiches zu absorbieren und Licht bei einem anderen Wellenlängenbereich zu emittieren.

8. Beleuchtungsvorrichtung nach Anspruch 7,
wobei der absorbierte Anteil des eintretenden Lichtes höchstens 50 % beträgt.

9. Photovoltaische oder Photoempfängervorrichtung, umfassend eine oder eine Mehrzahl von Photosolarzellen oder von Photodetektoren und einen Licht- Konzentrator nach einem der Ansprüche 1 bis 5,
wobei die Photosolarzelle oder der Photodetektor (4) an der kleineren Basisfläche (22) der Lichtleitzelle (2) angeordnet ist.

10. Verfahren zur Erzeugung von Licht- Konzentratoren oder- Verteiler in Form von transparenten Lichtleitkörpern (1) nach einem der Ansprüche 1 bis 5, mit folgenden Schritten:
- Bereitstellen eines transparenten Dielektrikumkörpers als Werkstück mit der äußeren Form des herzustellenden Lichtleitkörpers (1),
- Herstellen von Kanälen in dem Dielektrikumkörper entlang der Mäntel (23) von Pyramidenstümpfen, Kegelstümpfen, Paraboloidstümpfen oder konischen Waben, wobei mit vorbereitender unterstützender Laserbestrahlung innere Grenzflächen von Lichtleitzellen (2) gebildet und danach der Dielektrikumkörper entlang der laserbestrahlten inneren Grenzflächen geätzt wird.

11. Verfahren nach Anspruch 10,
wobei die inneren Grenzflächen der Lichtleitzellen (2) mit Hilfe von Sägen, Schleifmittel und Poliermittel bearbeitet werden.

12. Verfahren zur Erzeugung von Licht-Konzentratoren oder -Verteiler in Form von transparenten Lichtleitkörpern (1), die eine Mehrzahl von Lichtleitzellen (2) beherbergen, welche durch innere Grenzflächen als Mäntel von Pyramidenstümpfen, Kegelstümpfen, Paraboloidstümpfen oder konischen Waben begrenzt werden, nach einem der Ansprüche 1 bis 5, mit folgenden Schritten:
a) Bereitstellen eines transparenten Dielektrikumkörpers als Werkstück mit der äußeren Form des herzustellenden Licht-Konzentrators oder -Verteilers,
b) Fokussieren von Laserstrahlung (50, 60, 70) auf eine einzuschreibende Punktstelle (12) des Mantels (23) einer herzustellenden Lichtleitzelle (2) und Erzeugung eines Strukturierungselementes an der Punktstelle,
c) Verstellen des Werkstückes relativ zu der fokussierten Laserstrahlung auf eine neue einzuschreibende Punktstelle des Mantels (23) der gerade herzustellenden Lichtleitzelle (2),
d) Wiederholen der Schritte b) und c) für immer neue einzuschreibende Punktstellen der gerade herzustellenden Lichtleitzelle (2), bis diese vervollständigt ist,
e) Fokussieren von Laserstrahlung (50, 60, 70) auf eine einzuschreibende Punktstelle des Mantels (23) einer weiteren Lichtleitzelle (2) und Erzeugung eines Strukturelementes an der Punktstelle,
f) Wiederholen der Schritte c) und d) für jeweils herzustellende Lichtleitzellen (2), bis der Lichtleitkörper (1) hergestellt ist.

13. Verfahren nach Anspruch 12,
wobei im Schritt c) mit einem Punktabstand kleiner als 500 nm, bevorzugt kleiner als 100 nm und besonders bevorzugt kleiner als 20 nm gearbeitet wird.

14. Verfahren nach Anspruch 12 oder 13,
wobei ein Pikosekundenlaser zur Erzeugung von Punktstellen mit variiertem Brechungsindex eingesetzt wird, wobei im Brennpunkt der Laserstrahlung durch hohe Feldstärke eine Verdichtung des Materials mit Erhöhung des Brechungsindex und im Nachbarbereich des Brennpunktes eine Verdünnung des Materials mit Verringerung des Brechungsindex einhergeht.

15. Verfahren nach einem der Ansprüche 12 bis 14,
wobei gepulste Laserstrahlung (60, 70) mit Wellenlänge im Bereich von 180 bis 2000 nm und einer Energiedichte größer 2 J/cm² an den Punktstellen zur Bildung von Nano-Rissen eingesetzt wird.

16. Verfahren nach Anspruch 15,
wobei die Punktstellen mit Laserstrahlung (60, 70) aus zwei Laserquellen (6, 7) bearbeitet werden.

17. Verfahren nach Anspruch 10,
wobei gepulste Laserstrahlung (70) mit Wellenlänge im Bereich von 180 bis 2000 nm und mit einer Energiedichte größer 100 J/cm² entlang von zu erzeugenden Kanälen im Werkstück angewendet wird.

18. Verfahren nach einem der Ansprüche 10 bis 17,
wobei entstehende Dämpfe während der Prozessierung abgesaugt werden.

19. Vorrichtung zur Durchführung des Verfahrens nach einem der Ansprüche 12 bis 18, umfassend:
- einen Laser (5, 6, 7) zur Abgabe von Laserstrahlung (50, 60, 70) vorgegebener Intensität,
- ein Mikroskopobjektiv (57, 67, 77) zur Fokussierung der Laserstrahlung auf einen Brennpunkt innerhalb eines Dielektrikumkörpers als Werkstück,
- einen Werkstückhalter (10), der zur Feinpositionierung des Werkstückes relativ zu dem Brennpunkt der Laserstrahlung und zur gesteuerten Verschiebung des Werkstückes eingerichtet ist und
- eine Steuereinrichtung (58, 68, 78) mit Leistungsmesser (56, 66, 76) der Laserstrahlung zur Steuerung und Regelung des Lasers (5, 6, 7) hinsichtlich Pulsabgabe und Strahlungsintensität sowie zur Steuerung des Werkstückhalters (10), um innerhalb des Werkstückes Punktstellen zeilenmäßig auf Mantelschrägflächen von Pyramidenstümpfen, Kegelstümpfen, Paraboloidenstümpfen oder konischen Waben einzuschreiben und so die Lichtleitzellen (2) zu bilden, wobei Verstellbeträge auch weniger als die Wellenlänge des Nutzlichtes im herzustellenden Lichtleitkörper (1)- gefahren werden können.

20. Vorrichtung nach Anspruch 19,
wobei die Verstellbeträge kleiner als 500 nm, bevorzugt kleiner als 100 nm und besonders bevorzugt kleiner als 20 nm sind.

21. Vorrichtung nach Anspruch 19 oder 20,
wobei der Laser ein Ti:Al₂O₃-Laser (5) mit Pulsbreite kleiner 100 fs und Wellenlänge im Bereich von 180 bis 2000 nm ist.

22. Vorrichtung nach Anspruch 19 oder 20,
wobei der Laser ein XeF-Laser (7) und/oder ein Nd-YAG-Laser (6) mit Pulsbreite im Bereich von 1 ps und Wellenlänge im Bereich 180 bis 400 nm ist.

23. Vorrichtung nach Anspruch 19 oder 20,
wobei der Laser ein XeF-Laser (7) mit Pulsbreite im Bereich von 100 fs bis 10ns und einer Wellenlänge im Bereich 180 bis 400 nm ist.
